# EUROPEAN PATENT APPLICATION

(11) **EP 4 827 250 A1**
(43) Date of publication of application: **21.10.2026**
(21) Application number: 24912650.9
(22) Date of filing: 20.12.2024
(51) Int. Cl.: H05K 3/34

(54) **JET SOLDERING APPARATUS**

(30) Priority: 26.12.2023 JP 2023219464
(71) Applicant: Senju Metal Industry Co., Ltd., Tokyo 120-8555 (JP)
(72) Inventor: ICHIKAWA, Hirokazu, Tokyo 120-8555 (JP); KAGAYA, Tomotake, Tokyo 120-8555 (JP); OZAWA, Satoshi, Tokyo 120-8555 (JP); KURAMOTO, Kyoko, Tokyo 120-8555 (JP)
(74) Representative: Hindles Limited
(86) International application number: PCT/JP2024/045112
(87) International publication number: WO 2025/142761

(57) **Abstract**

A jet soldering apparatus has a storage tank 110 that stores molten solder S and a supply part 125 that has a plurality of nozzles 127 for supplying the molten solder S. Heights of the nozzles 127 are 3 mm or more and 10 mm or less.

## Description

### [TECHNICAL FIELD]

The present invention relates to a jet soldering apparatus that supplies molten solder to a substrate.

### [BACKGROUND ART]

Conventionally, a jet soldering apparatus for supplying molten solder to a substrate has been known. For example, JP 2019-114718 A discloses a jet solder tank that performs soldering by jetting molten solder into contact with a substrate, the jet solder tank including a first jet nozzle that jets the molten solder by a first jet pump, and a second jet nozzle that is disposed on a downstream side of the first jet nozzle with respect to a conveyance direction of the substrate and jets molten solder by a second jet pump.

### [SUMMARY OF INVENTION]

### [PROBLEM TO BE SOLVED BY INVENTION]

In the conventional jet soldering apparatus, soldering to a substrate could not always be performed reliably.

The present invention provides a jet soldering apparatus that can perform soldering to a substrate more reliably.

### [MEANS FOR SOLVING PROBLEM]

### [Concept 1]

A jet soldering apparatus according to the present invention may comprise:
a storage tank that stores molten solder; and
a supply part that has a plurality of nozzles for supplying the molten solder,
wherein heights of the nozzles may be 3 mm or more and 10 mm or less.

### [Concept 2]

In the jet soldering apparatus according to concept 1,
a center-to-center spacing between the nozzles in a substrate conveyance direction may be larger than a center-to-center spacing between the nozzles in a direction orthogonal to the substrate conveyance direction.

### [Concept 3]

In the jet soldering apparatus according to concept 1 or 2,
heights of all nozzles may be the same height.

### [Concept 4]

In the jet soldering apparatus according to any one of concepts 1 to 3,
the plurality of nozzles may be arranged in three rows in a substrate conveyance direction.

### [Concept 5]

In the jet soldering apparatus according to any one of concepts 1 to 4,
heights of the nozzles may be 5 mm or more.

### [Concept 6]

In the jet soldering apparatus according to any one of concepts 1 to 5,
heights of the nozzles may be 7 mm or less.

### [Concept 7]

In the jet soldering apparatus according to any one of concepts 1 to 6,
center-to-center spacing between the plurality of nozzles may be 9 mm or more and less than 20 mm.

### [Concept 8]

In the jet soldering apparatus according to any one of concepts 1 to 7,
the plurality of nozzles may be arranged in plurality rows in a substrate conveyance direction, and
height of the nozzles in the last row in the substrate conveyance direction may be lower than heights of the nozzles in the other rows.

### [Concept 9]

In the jet soldering apparatus according to any one of concepts 1 to 8,
the molten solder may contain Bi at 35 mass% or more.

### [Concept 10]

In the jet soldering apparatus according to any one of concepts 1 to 9,
height position of the plurality of nozzles may be adjustable.

### [EFFECT OF INVENTION]

In the present invention, by adopting an aspect in which the height of a nozzle is 3 mm or more, soldering to a substrate can be more reliably performed. In addition, by setting the height of a nozzle to 10 mm or less, the solder can be prevented from being oxidized.

### [BRIEF DESCRIPTION OF FIGURES]

[FIG. 1] FIG. 1 is a schematic view showing a soldering apparatus according to the present embodiment.
[FIG. 2] FIG. 2 is a side cross-sectional view showing an aspect in which the heights of nozzles in a first supply part are the same in a jet soldering apparatus according to the present embodiment.
[FIG. 3] FIG. 3 is a plan view showing an example of the jet soldering apparatus according to the present embodiment.
[FIG. 4] FIG. 4 is a perspective view showing a plurality of nozzles in the first supply part according to the present embodiment.
[FIG. 5] FIG. 5 is a side cross-sectional view showing one nozzle according to the present embodiment.
[FIG. 6] FIG. 6 is a view of a plurality of nozzles in the first supply part according to the present embodiment as viewed from a bottom surface side.
[FIG. 7] FIG. 7 is a side cross-sectional view showing an aspect in which the heights of the nozzles in the last row (third row) of the nozzles in the first supply part are lower than the heights of the nozzles in the first row and the second row in the jet soldering apparatus according to the present embodiment.

### [EMBODIMENT FOR IMPLEMENTING INVENTION]

### Configuration

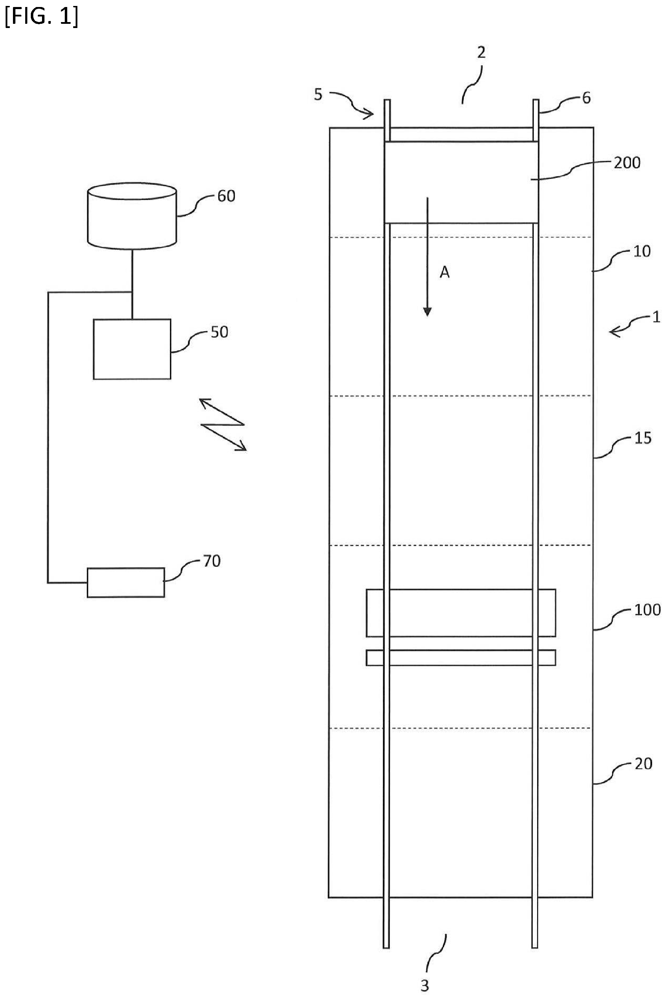

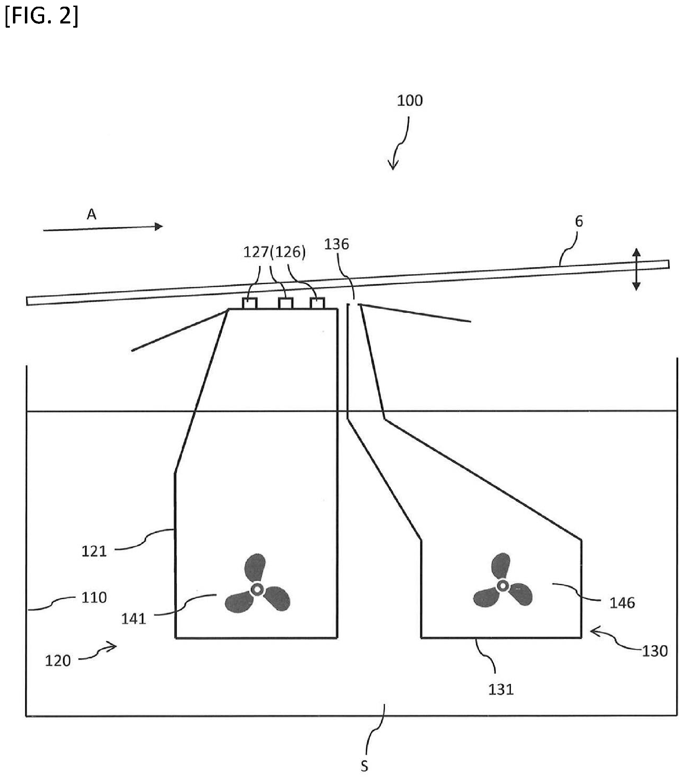

A soldering apparatus illustrated in FIG. 1 is an apparatus that performs soldering processing on a substrate 200 on which electronic components such as semiconductor elements, resistors, and capacitors are mounted on a circuit. Typically, the electronic components and the like are positioned on a lower side of the substrate 200. The soldering apparatus has a main body 1 and a conveyance unit 5 that conveys the substrate 200. The main body 1 has a carry-in port 2 through which the substrate 200 is carried in and a carry-out port 3 through which the substrate 200 is carried out. The substrate 200 may be conveyed at a predetermined angle, for example, an inclination of about 3 to 6 degrees when viewed from the side (see FIG. 2). In this case, a downstream side is positioned at a higher position than an upstream side in a substrate conveyance direction A. However, the present invention is not limited thereto, and the substrate 200 may be horizontally conveyed, for example. The conveyance unit 5 may have a conveyance driver (not illustrated) that applies a driving force for transporting the substrate 200, and a conveyance rail 6 that guides the substrate 200.

As illustrated in FIG. 1, the main body 1 may be provided with a fluxer 10 for applying flux to the substrate 200, a preheater unit 15 for preheating the substrate 200 coated with flux, a jet soldering apparatus 100 for jetting molten solder into contact with the substrate 200, and a cooler 20 for cooling the soldered substrate 200. The substrate 200 conveyed along the conveyance rail 6 of the conveyance unit 5 sequentially passes through the fluxer 10, the preheater unit 15, the jet soldering apparatus 100, and the cooler 20. The jet soldering apparatus 100 may have a control unit 50 that gives a command to each component to control, a storage unit 60 that stores various pieces of information, and an operation unit 70 that an operator uses to operate the soldering apparatus by inputting various information. In

FIG. 1, the soldering apparatus is illustrated in an upper plan view except for the control unit 50, the storage unit 60, and an operation unit 70.

The fluxer 10 is used to apply flux to the conveyed substrate 200. The flux may include a solvent, an activator, and the like. The fluxer 10 may be provided with a plurality of coating apparatuses. The type of flux may be selectively used according to the type of solder and the type of the substrate 200.

The preheater unit 15 heats the substrate 200 to uniformly raise the substrate 200 to a predetermined temperature. When the substrate 200 is heated in this manner, the solder is easily attached to a predetermined part of the substrate 200. For example, a far-infrared panel heater is used as the preheater unit 15. The far-infrared panel heater can rapidly heat the substrate 200 to a set temperature. Furthermore. The substrate 200 may be heated by blowing gas (hot air) heated by the heater onto the substrate 200 by a fan. Furthermore, as the preheater unit 15, a halogen heater or the like may be used.

The cooler 20 has a cooling fan which is not illustrated, and cools the substrate 200 soldered by the jet soldering apparatus 100. The control of the cooling fan may be only ON and OFF, but the wind speed may be adjusted. Furthermore, as the cooler 20, a chiller or the like may be used to cool the substrate 200 to a predetermined temperature.

The control unit 50 illustrated in FIG. 1 is communicably connected to the conveyance unit 5 including the conveyance rail 6, the fluxer 10, the preheater unit 15, the jet soldering apparatus 100, the cooler 20, the operation unit 70, and the storage unit 60. The communicable connections include both wired and wireless connections. The operation unit 70 may have a liquid crystal display panel, a numeric keypad, or the like, and is typically a personal computer, a smartphone, a tablet or the like. When an operator operates the operation unit 70, the control unit 50 may control a conveyance speed by the conveyance unit 5, a timing of conveying the substrate 200, a temperature of the flux at the fluxer 10, an application amount of the flux, a temperature of the preheater unit 15, a temperature of molten solder S of the jet soldering apparatus 100, a jet amount, a jet speed, ON and OFF of the cooling fan of the cooler 20, and the like. The storage unit 60 may store information input by the operation unit 70, an instruction of the control unit 50, an operating time of the jet soldering apparatus 100, and the like.

As illustrated in FIG. 2, the jet soldering apparatus 100 has a storage tank 110 that stores molten solder S, and a supply part that supplies the molten solder S to a substrate 200. In the present embodiment, the supply part has a first supply part 120 and a second supply part 130. The first supply part 120 may have a first pump 141 which is a first drive part. Similarly, the second supply part 130 may have a second pump 146 which is a second drive part. The molten solder S jetted from the first supply part 120 and the second supply part 130 is jetted upward from below. The molten solder S having received the driving force from the first pump 141 is pressure-fed in a duct and jetted toward the substrate 200 to attach the solder to a predetermined part of the substrate 200. Similarly, the molten solder S having received the driving force from the second pump 146 is pressure-fed in a duct and jetted toward the substrate 200 to attach the solder to a predetermined part of the substrate 200. The molten solder S is heated to a temperature of, for example, about 180°C. to 250°C. by a heater which is not illustrated. The molten solder S supplied from the first supply part 120 and the second supply part 130 may be circulated and used. In this case, it may be circulated through a filter which is not illustrated. Each of the first pump 141 and the second pump 146 is typically constituted of one pump, but each of the first pump 141 and the second pump 146 may be constituted of a plurality of pumps.

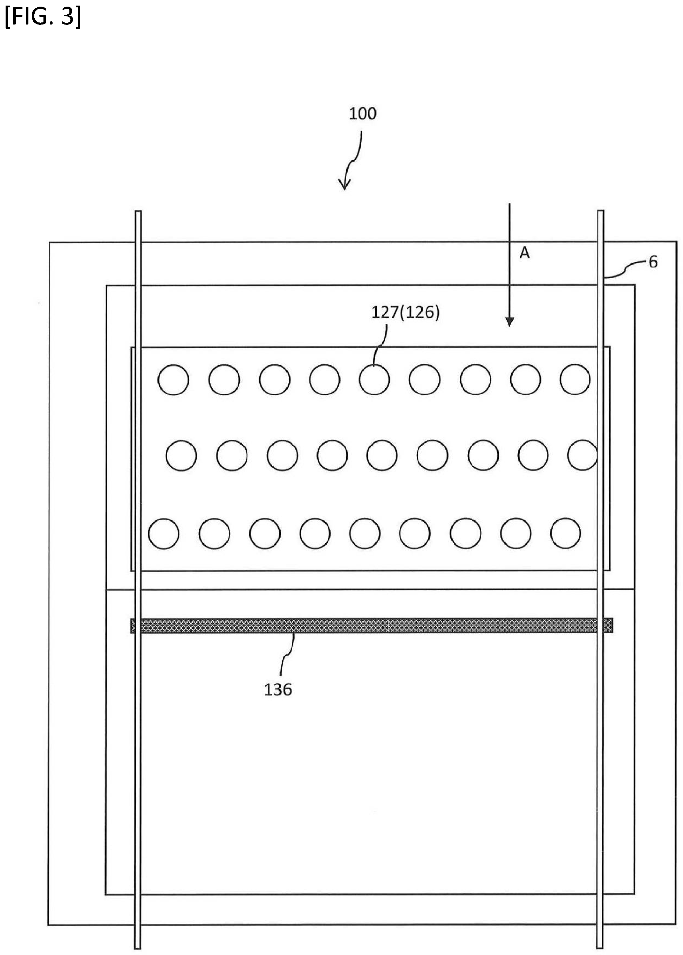

The first supply part 120 of the jet soldering apparatus 100 illustrated in FIG. 2 has a plurality of first openings 126 (see FIG. 3 etc.). The plurality of first openings 126 are used to vigorously supply a large amount of molten solder S to the substrate 200. A second opening 136 of the second supply part 130 is used to supply the molten solder S to the substrate 200 with weaker force than the first supply part 120. The jet solder supplied from the first supply part 120 is a dynamic supply for vigorously colliding the molten solder S against the substrate 200, and is a supply for spreading the molten solder S to every corner of the substrate 200. On the other hand, the jet solder supplied from the second supply part 130 is a static supply, and is a supply for cleanly attaching the solder to an electrode or the like of the substrate 200 by passing the jet solder through the molten solder S having a gentle flow.

As illustrated in FIG. 2, the first supply part 120 has a first housing 121, and one or a plurality of first openings 126 that are provided on an upper surface of the first housing 121 and supply the molten solder S. In the present embodiment, the first opening 126 has a nozzle shape that protrudes upward from an upper surface of the first housing 121. The second supply part 130 has a second housing 131, and one or a plurality of second openings 136 that are provided on an upper surface of the second housing 131 and supply the molten solder S. The first housing 121 and the second housing 131 may be provided apart from each other, but these may be provided integrally. In the present embodiment, description will be given using, as an example, the first opening 126, which has a plurality of nozzles 127, and one slit-shaped second opening 136 (see FIG. 3 and the like). However, there is no limitation to such an aspect, and for example, a plurality of slit-shaped second openings 136 may be provided, and in this case, the plurality of slit-shaped second openings 136 may be provided in an aspect of extending in parallel. The second opening 136 may also have a plurality of nozzles. In the present embodiment, description will be given using an aspect in which the first opening 126 has a plurality of nozzles; however, in a case where the second opening 136 has a plurality of nozzles, any aspect described for the nozzle 127 that is the first opening 126 can be adopted in the nozzles. The shape of the nozzle does not need to be a cylindrical shape, and may be, for example, a polygonal columnar shape such as a triangular prism or a quadrangular prism, or may be another shape (for example, a cross-section of the opening may have an elliptical shape, may have a cross shape, or may have a star shape). In addition, an area of the cross-section of the nozzle may be 9π to 25π mm² (approximately 28.26 to 78.5 mm²).

While the molten solder S is being supplied, the molten solder S supplied from the first supply part 120 and the molten solder S supplied from the second supply part 130 may be mixed with each other. A configuration may be adopted in which the molten solder S mixed in this manner does not separate from the substrate 200 conveyed by the conveyance unit 5 between the first supply part 120 and the second supply part 130. The substrate 200 is supported and conveyed by the conveyance rail 6, and the upper surface of the mixed molten solder S may not be positioned below the lower end of the conveyance rail 6 that conveys the substrate 200 when viewed from the side, in the entire length region along the substrate conveyance direction A between the first supply part 120 and the second supply part 130. In this case, a configuration is obtained in which the molten solder S does not separate from the substrate 200 conveyed by the conveyance unit 5 between the first supply part 120 and the second supply part 130.

An aspect may be adopted in which the molten solder S supplied from the first supply part 120 and the molten solder S supplied from the second supply part 130 merge with each other and are ejected to a position higher than the conveyance position of the substrate 200; however, there is no limitation to such an aspect, and an aspect may be adopted in which a location where the molten solder S does not contact the substrate 200 is provided between the molten solder S supplied from the first supply part 120 and the molten solder S supplied from the second supply part 130, and the molten solder S is ejected in two clearly separate stages.

A temperature of the molten solder S is generally a melting temperature of the solder +50°C. In recent years, there has been an increasing need to lower a working temperature in order to reduce damage to components and reduce mechanical power consumption. In addition, since the market price of Sn and Ag has soared, it has been examined to use solder that does not use Sn and Ag, and typically, it has been examined to use Sn-58Bi (melting point 139°C) instead of Sn-3Ag-0.5Cu (melting point 217°C). Sn-58Bi is a low-temperature eutectic solder. Note that, when Sn-58Bi is used, soldering can be performed at a temperature of 200°C. or lower. On the other hand, since Sn-58Bi has a low surface tension, solder supplied from the nozzle 127 of the first supply part 120 tends to have difficulty forming a bead shape. In addition, Sn-58Bi has a property of being susceptible to oxidation. These tendencies are observed with solder containing Bi, and are particularly remarkable with solder containing Bi at 35 mass% or more.

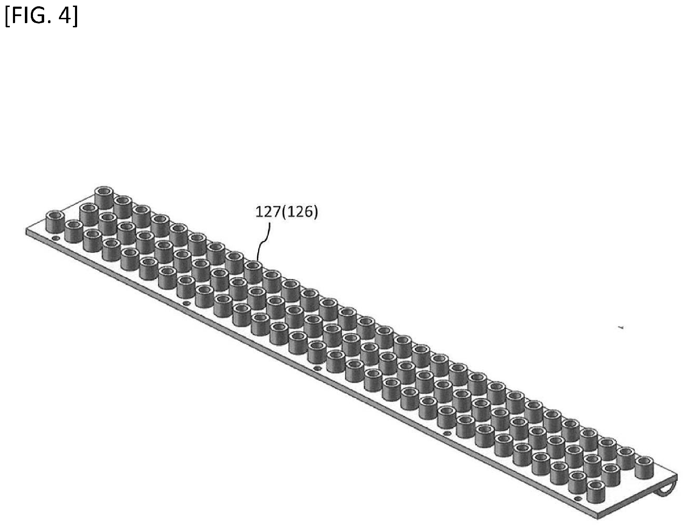

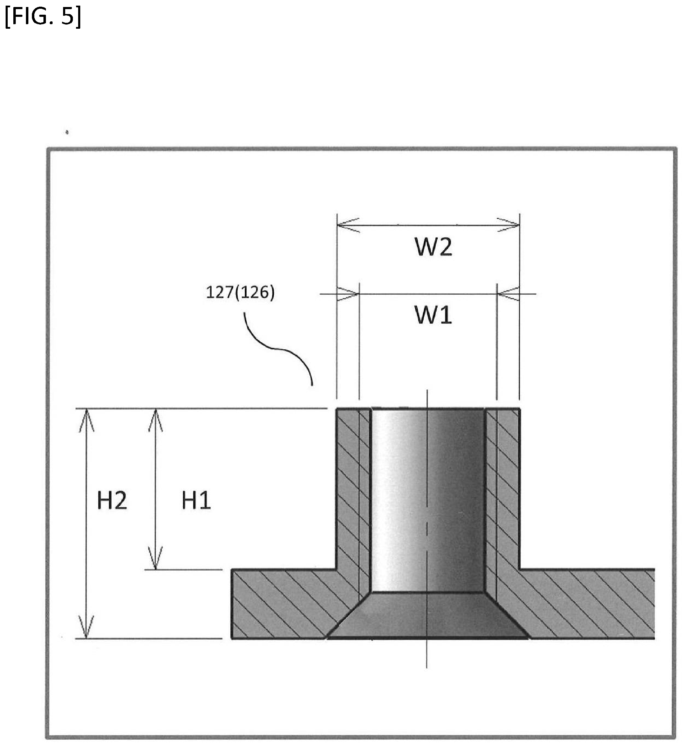

In the present embodiment, the height of the nozzle 127 in the first supply part 120 is 3 mm or more and 10 mm or less (see FIG. 4). The present inventors have confirmed that by setting the height of the nozzle 127 to 3 mm or more, the molten solder S ejected from the nozzle 127 can form a bead shape, and the molten solder S can be firmly attached to the substrate 200. In addition, when the height of the nozzle 127 is too high, oxidation tends to occur when the molten solder S falls, and therefore, it is preferable that the height of the nozzle 127 is 10 mm or less. In FIG. 5, H1 is the height of the nozzle 127, and H2 is a value that includes a thickness of the top surface of the first supply part 120.

In terms of enhancing the effect of forming the molten solder S to be ejected into a bead shape, the height of the nozzle 127 is preferably 4 mm or more, and more preferably 5 mm or more. In order to prevent the molten solder S from being oxidized when falling, the height of the nozzle 127 is preferably 8 mm or less, and more preferably 7 mm or less.

The heights of all nozzles 127 may be the same. As an example, the upper surface of the first housing 121 may extend parallel to a horizontal plane without being inclined, and the heights of all nozzles 127 extending upward from the upper surface may be the same. As illustrated in FIG. 2, in a case where an aspect is adopted in which the conveyance rail 6 is raised on the downstream side in the substrate conveyance direction A (the right side in FIG. 2) (the height position on the downstream side is higher compared to the upstream side), it is advantageous in that, by adopting such an aspect, a large amount of molten solder S can initially be provided to the substrate, and a small amount of molten solder S can be provided toward the downstream side.

The nozzle 127 may be formed integrally with the upper surface of the first housing 121 so as not to be removable or adjustable in height. In a case where the nozzle 127 is removable or adjustable in height, the height position of the nozzle 127 may be unintentionally changed. On the other hand, by adopting the present aspect, it is advantageous in that an unintended change in the height position of the nozzle 127 can be prevented in advance.

The nozzle 127 may be a screw type or a slide type, and the height position thereof may be adjustable. In a case where such an aspect is adopted, the height position of the nozzle 127 can be adjusted according to the type of the substrate 200, for example. In this case, an adjustment range may be approximately 0.1 mm to 3 mm.

As described above, since solder containing Bi tends to have a weak surface tension, an aspect in which the height of the nozzle 127 is 3 mm or more is particularly advantageous when using solder containing Bi. In addition, since solder containing Bi has a high tendency to oxidize, an aspect in which the height of the nozzle 127 is 10 mm or less is particularly advantageous when using solder containing Bi. In addition, since such a tendency is stronger in solder containing Bi at 35 mass% or more, it is very advantageous to use the present embodiment with Sn-58Bi or the like containing Bi at 35 mass% or more.

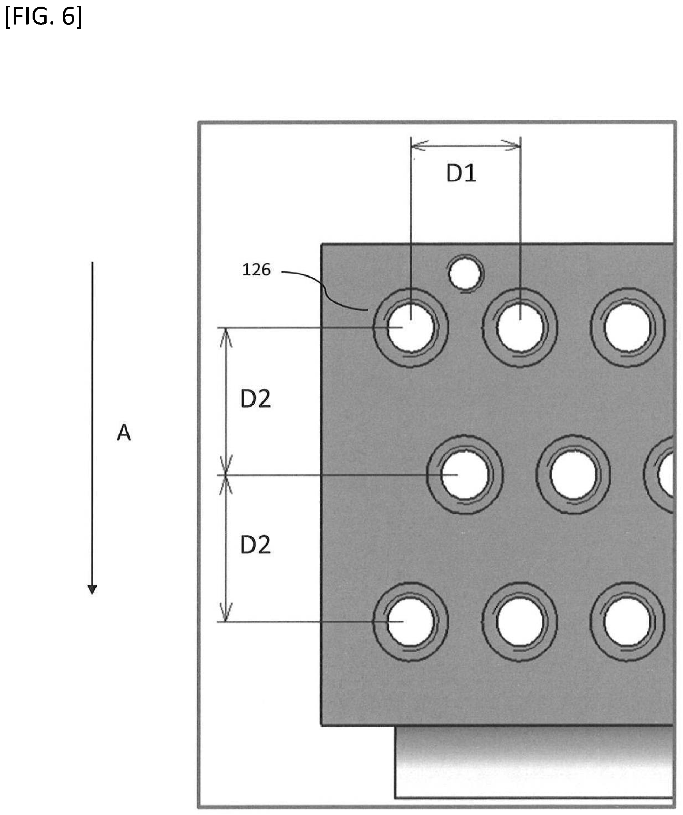

As illustrated in FIGS. 3, 4, and 6, the plurality of nozzles 127 may be arranged in three rows in the substrate conveyance direction A. In a case where the nozzles are arranged in four or more rows, when the nozzles 127 are separated to have a certain distance therebetween, the length of the first supply part 120 in the substrate conveyance direction A (the length in the short-side direction) becomes long; however, in a case where the nozzles are arranged in three rows, the nozzles 127 can be separated to have a certain distance therebetween while preventing the length of the first supply part 120 in the substrate conveyance direction A from becoming too long.

The center-to-center spacing between the plurality of nozzles 127 is preferably 9 mm or more and less than 20 mm. In a case where the center-to-center spacing is less than 9 mm, a distance over which the molten solder S is ejected from the nozzle 127 becomes shorter, which may cause the bead shape of the molten solder S to collapse. When the bead shape of the molten solder S collapses in this manner, an effect of adhesion of the molten solder S to the substrate 200 is diminished. On the other hand, when the center-to-center spacing is 20 mm or more, a supply amount of the molten solder S per unit area decreases, and there is a possibility that the molten solder S cannot be efficiently supplied to the substrate 200. The center-to-center spacing is preferably 19 mm or less. The center-to-center spacing may be 18 mm or less, may be 17 mm or less, may be 16 mm or less, or may be 15 mm or less.

A center-to-center spacing D2 between the nozzles 127 in the substrate conveyance direction A (the short-side direction of the first supply part 120) and the center-to-center spacing D1 between the nozzles 127 in the direction orthogonal to the substrate conveyance direction A (the long-side direction of the first supply part 120) may be different from each other, and the center-to-center spacing D2 between the nozzles 127 in the short-side direction may be larger than the center-to-center spacing D1 between the nozzles 127 in the long-side direction. The center-to-center spacing D2 between the nozzles 127 in the short-side direction may be set to be 1.1 times or more of the center-to-center spacing D1 between the nozzles 127 in the long-side direction, or may be set to be 1.2 times or more thereof. By adopting such an aspect, it can be expected that the bead shape of the solder supplied from the nozzle 127 is prevented as much as possible from collapsing due to the solder from the nozzles 127 adjacent in the short-side direction, while the supply amount of solder is maintained by the plurality of nozzles 127 arranged in the long-side direction (direction orthogonal to the substrate conveyance direction A).

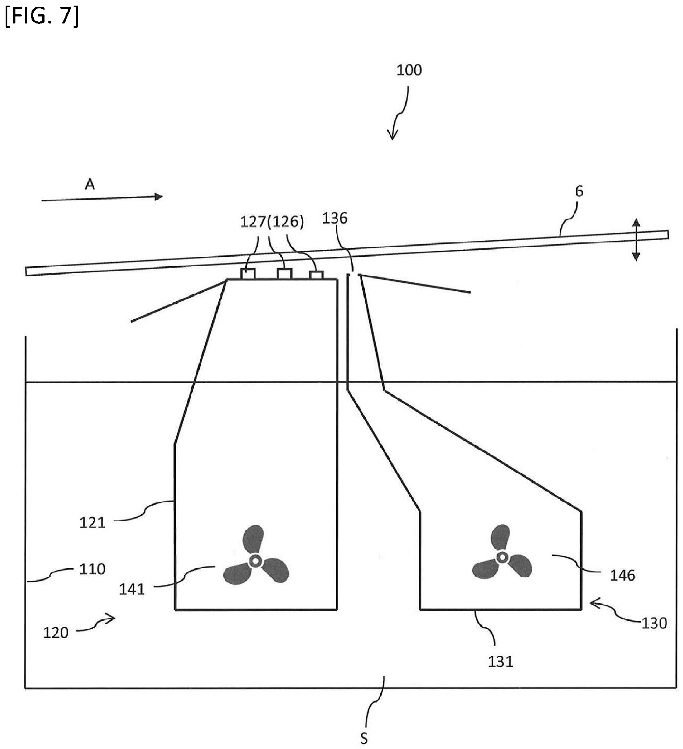

It is also possible to adopt an aspect in which the height of the nozzles 127 in the last row in the substrate conveyance direction A (the nozzles 127 at the right end in FIG. 7) is lower than the heights of the nozzles 127 in other rows. The present inventors have confirmed that if solder having a bead shape can be supplied to the substrate 200 on the upstream side in the substrate conveyance direction A, solder can be efficiently attached to the substrate 200. On the other hand, even when the heights of the nozzles 127 in the last row in the substrate conveyance direction A are increased, there are cases where solder having a bead shape cannot be supplied by the molten solder S supplied from the second supply part; and therefore, it may also be advantageous to make the heights of the nozzles 127 in the last row in the substrate conveyance direction A lower and avoid problems caused by oxidation of the molten solder S.

In order to promote separation of dross generated by oxidation of the solder, saccharides such as rice bran, wheat bran, barley bran, legumes, sesame, sunflower, palm, rapeseed, vegetable oil, and wood flour, as well as pine resin, ammonium chloride, halides of an amine, and the like, may be provided to the molten solder S as an oxidation separator.

Next, an example of a processing method of a substrate 200 will be described mainly with reference to FIG. 1.

When an operator places the substrate 200 on the conveyance rail 6, the conveyance unit 5 conveys the substrate 200, and the substrate 200 is conveyed into the main body 1 from the carry-in port 2. When the substrate 200 reaches the fluxer 10, the fluxer 10 applies flux to a predetermined part of the substrate 200.

The conveyance unit 5 conveys the substrate 200 coated with the flux by the fluxer 10 to the preheater unit 15. The preheater unit 15 heats the substrate 200 to a predetermined temperature.

Next, the conveyance unit 5 conveys the substrate 200 heated to the predetermined temperature by the preheater unit to the jet soldering apparatus 100. The jet soldering apparatus 100 solders a predetermined part of the substrate 200. While the jet soldering apparatus 100 is supplying the molten solder S, the molten solder S supplied from the first supply part 120 and the molten solder S supplied from the second supply part 130 are mixed, and the molten solder S is supplied to above the conveyance rail 6. In this case, since the height of the nozzle 127 in the first supply part 120 is 3 mm or more, the molten solder S ejected from the nozzle 127 can form a bead shape, and the molten solder S can be firmly attached to the substrate 200. In addition, by setting the height of the nozzle 127 to 10 mm or less, oxidation of the molten solder S can be prevented. As described above, since solder containing Bi (in particular, solder containing Bi at 35 mass% or more, such as Sn-58Bi) has a low surface tension, solder supplied from the first supply part 120 tends to have difficulty forming a bead shape, and has a property of being susceptible to oxidation, and therefore it is extremely advantageous to adopt the aspect of the present embodiment.

Next, the conveyance unit 5 conveys the soldered substrate 200 to the cooler 20. For example, a cooling fan of the cooler 20 cools the soldered substrate 200 for a predetermined period of time. After the substrate 200 is cooled, when the conveyance unit 5 discharges the substrate 200 from the carry-out port 3, the soldering process for the substrate 200 is complete.

### [EXAMPLE]

In order to confirm the effects of the present embodiment, experimental results (evaluation of unsoldered point prevention performance) conducted by the present inventors will be described.

Fifteen sheets of evaluation substrates (glass epoxy substrate (FR-4, size: 215.4 x 140.3 mm, thickness: 1 mm, Cu-OSP), number of soldering points: 498 locations) were attached to a pallet mask provided with an opening at a location to be soldered. Thereafter, soldering was performed on the evaluation substrates attached to the pallet mask using the nozzles 127 shown in Tables 1 and 2 under the following soldering conditions.

### (Soldering conditions)

Soldering apparatus: "BITHUS-Wave MTF-300" manufactured by Senju Metal Industry Co., Ltd.
Flux application apparatus: Spray fluxer ("SSF-400" manufactured by Senju Metal Industry Co., Ltd.)
Flux application amount: 70 mL/m²
Conveyor speed (conveying speed of conveyance unit 5): 1.2 m/min
Substrate temperature (average temperature): 120°C
Solder tank temperature: 199°C
Alloy composition of solder: Sn-58Bi

The evaluation substrates after soldering were visually observed, and solderability was evaluated in accordance with the following criteria. In each of Examples and Comparative Examples, a nozzle having a circular cross-section and a diameter of 6 mm (cross-sectional area: 9π mm²) was used. The evaluation results are as shown in Tables 1 and 2.

### [Unsoldered point evaluation]

∘: No occurrence of unsoldered points (1 or fewer)
×: Occurrence of unsoldered points (2 or more)

### [Dross increase]

∘: Dross increase within a normally acceptable range
×: Significant dross increase

**[Table 1]**

| | Nozzle height (mm) | Nozzle spacing D1 (mm) | Number of unsoldered points | Unsoldered point evaluation | Dross increase | Overall evaluation |
|---|---|---|---|---|---|---|
| Example 1 | 5 | 15 | 0 | O | O | ⊚ |
| Example 2 | 5 | 9 | 0 | O | O | ⊚ |
| Example 3 | 7 | 9 | 0 | O | O | ⊚ |
| Comparative Example 1 | 2 | 8 | 45 | × | ○ | × |
| Comparative Example 2 | 16 | 21 | 8 | × | × | × |

**[Table 2]**

| | Nozzle height (mm) | Nozzle spacing D1 (mm) | Number of unsoldered points | Unsoldered point evaluation | Dross increase | Overall evaluation |
|---|---|---|---|---|---|---|
| Example 4 | 5 | 18 | 0 | O | O | ⊚ |
| Example 5 | 8 | 18 | 0 | O | O | ⊚ |
| Example 6 | 5 | 19 | 0 | O | O | ⊚ |
| Example 7 | 10 | 10 | 0 | ○ | ○ | ⊚ |

As shown in Comparative Example 1, in a case where the height of the nozzle 127 was 2 mm, among 498 locations, there were 45 locations where solder was not attached. In Comparative Example 2, the amount of dross generated in the molten solder S increased significantly.

The above description of each embodiment and the disclosure of the drawings are merely examples for describing the invention defined in the claims, and the invention defined in the claims is not limited by the above description of each embodiment and the disclosure of the drawings. In addition, the description of the claims at the time of filing is only an example, and the description of the claims can be changed as appropriate based on the description of the description, drawings, and the like.

### [EXPLANATION OF REFERENCE]

- 110: Storage tank
- 120: First supply part (supply part)
- 127: Nozzle
- 130: Second supply part (supply part)
- S: Molten solder

## Claims

1. A jet soldering apparatus comprising:
a storage tank that stores molten solder; and
a supply part that has a plurality of nozzles for supplying the molten solder,
wherein heights of the nozzles are 3 mm or more and 10 mm or less.

2. The jet soldering apparatus according to claim 1,
wherein the plurality of nozzles are arranged in three rows in a substrate conveyance direction.

3. The jet soldering apparatus according to claim 1 or 2,
wherein heights of all nozzles are the same height.

4. The jet soldering apparatus according to claim 1 or 2,
wherein heights of the nozzles are 5 mm or more.

5. The jet soldering apparatus according to claim 1 or 2,
wherein heights of the nozzles are 7 mm or less.

6. The jet soldering apparatus according to claim 1 or 2,
wherein center-to-center spacing between the plurality of nozzles is 9 mm or more and less than 20 mm.

7. The jet soldering apparatus according to claim 1 or 2,
wherein the plurality of nozzles are arranged in plurality rows in a substrate conveyance direction, and
wherein height of the nozzles in the last row in the substrate conveyance direction is lower than heights of the nozzles in the other rows.

8. The jet soldering apparatus according to claim 1 or 2,
wherein the molten solder contains Bi at 35 mass% or more.

9. The jet soldering apparatus according to claim 1 or 2,
wherein height position of the plurality of nozzles are adjustable.
